Europäisches Patentamt

(19) European Patent Office

Office européen des brevets

(11) Numéro de publication: **0 033 683**
**A2**

(12) **DEMANDE DE BREVET EUROPEEN**

(21) Numéro de dépôt: 81400099.8

(22) Date de dépôt: 23.01.81

(51) Int. Cl.³: **H 01 L 31/02**
**F 24 J 3/02**

(30) Priorité: 01.02.80 FR 8002254

(43) Date de publication de la demande:
**12.08.81 Bulletin 81/32**

(84) Etats contractants désignés:
DE FR GB IT NL

(71) Demandeur: "LE SILICIUM SEMICONDUCTEUR SSC"
45, rue de Monceau
F-75008 Paris(FR)

(72) Inventeur: Arnould, Jacques
THOMSON-CSF SCPI 173, bld Haussmann
F-75360 Paris Cedex 08(FR)

(74) Mandataire: de Beaumont, Michel et al,
"THOMSON-CSF" SCPI 173, Bld Haussmann
F-75360 Paris Cedex 08(FR)

(54) Procédé de refroidissement d'une cellule solaire et dispositif solaire mixte photovoltaïque et photothermique.

(57) La présente invention concerne un procédé de refroidissement de cellule solaire.

Le dispositif mettant en oeuvre ce procédé comprend un ensemble transparent 5 disposé devant une cellule photovoltaïque 1. L'ensemble transparent 5, qui est traversé par le fluide de refroidissement 4 sortant d'un radiateur 3 solidaire de la cellule, absorbe les longueurs d'onde supérieures à 1, 1 micron. Ainsi, l'échauffement de la cellule est limité et le fluide sortant du radiateur 3 est rechauffé par le faisceau frappant la cellule 5.

Application à un dispositif solaire mixte photovoltaïque et photothermique.

Fig.1

1

## PROCEDE DE REFROIDISSEMENT D'UNE CELLULE SOLAIRE ET DISPOSITIF SOLAIRE MIXTE PHOTOVOLTAIQUE ET PHOTOTHERMIQUE

La présente invention concerne un procédé de refroidissement d'une cellule solaire et un dispositif solaire mixte photovoltaïque et photothermique.

On s'intéressera ici plus particulièrement aux dispositifs photovoltaïques destinés à servir de cellule solaire et fonctionnant en lumière concentrée. Le rendement de ces dispositifs est optimal quand leur température est faible. Notamment, dans le cas de cellules au silicium, il est souhaitable que la température ne dépasse pas une valeur de l'ordre de 50 à 60°C. Ainsi, de façon courante, on dispose les cellules solaires sur des radiateurs, éventuellement des radiateurs à circulation de fluide. La circulation de fluide doit être prévue de sorte que la température de sortie du fluide ne dépasse pas une valeur de l'ordre de 50 à 60°C. Un fluide à une telle température est difficilement utilisable pour des applications thermiques.

Ainsi, un objet de la présente invention est de prévoir un procédé et un dispositif améliorant le refroidissement d'un dispositif photovoltaïque.

Un autre objet de la présente invention est de prévoir un tel dispositif permettant de fournir de l'énergie thermique à une température plus élevée que la température directement compatible avec une cellule semiconductrice de type donné.

Pour atteindre ces objets ainsi que d'autres, la présente invention prévoit un procédé de refroidissement d'une cellule photovoltaïque solidaire d'un radiateur à circulation de fluide selon lequel on dispose, devant la cellule et dans le trajet du rayonnement incident, un ensemble traversé par le fluide de refroidissement et absorbant au moins une partie du rayonnement incident dont le spectre se trouve en dehors de la zone de sensibilité de la cellule. Cet ensemble peut comprendre des fenêtres transparentes entre lesquelles circule le fluide, les matériaux constitutifs des fenêtres et du fluide étant choisis pour qu'au moins une partie du rayonnement absorbé le soit directement par le fluide.

2

Un dispositif solaire mixte photovoltaïque et photothermique à lumière concentrée selon la présente invention comprend une cellule photovoltaïque solidaire d'un radiateur dans lequel circule un fluide de refroidissement; un ensemble disposé dans le trajet du faisceau incident; des moyens pour faire circuler le fluide dans cet ensemble; cet ensemble absorbant, en coopération avec le fluide, une partie au moins du rayonnement incident situé hors de la bande spectrale de réponse de la cellule photovoltaïque et transmettant les calories recueillies au fluide de refroidissement. L'ensemble en question comprend des fenêtres transparentes, par exemple en quartz, entre lesquelles circule le fluide de refroidissement, par exemple de l'eau. La lumière incidente peut être focalisée sur le fluide de refroidissement et légèrement défocalisée au niveau de la cellule photovoltaïque. Cette cellule peut être du type cellule au silicium à multijonctions verticales.

Ces objets, caractéristiques et avantages ainsi que d'autres de la présente invention seront exposés plus en détail dans la description suivante de modes de réalisation particuliers faite en relation avec les figures jointes parmi lesquelles :

— la figure 1 représente un dispositif selon la présente invention; et

— la figure 2 représente de façon plus détaillée une partie de la figure 1.

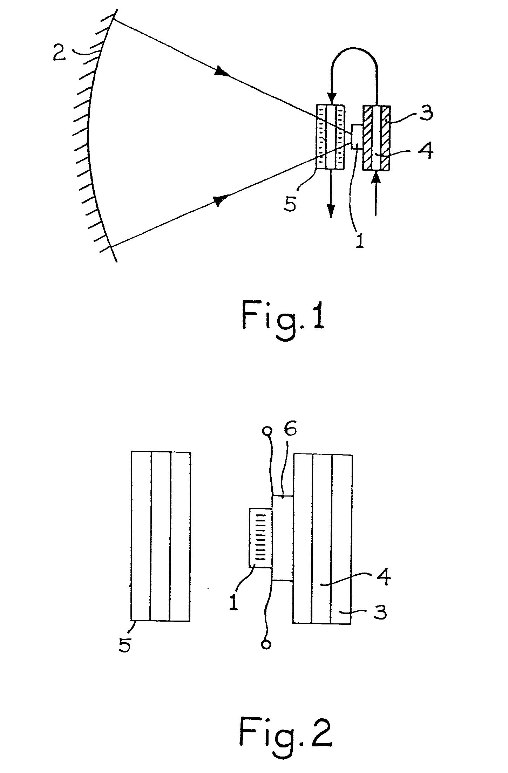

La figure 1 représente de façon schématique une cellule photovoltaïque 1 vers laquelle est transmis un faisceau lumineux concentré en provenance d'un réflecteur 2. Cette cellule est solidaire thermiquement d'un radiateur 3 dans lequel circule un fluide 4. Ce fluide 4 peut par exemple être de l'eau. Si l'eau entrant dans le radiateur 3 est à une température sensiblement égale à 20°C, il est souhaitable pour le bon fonctionnement du dispositif et l'accroissement du rendement de la cellule solaire 1, que la température de sortie reste faible, par exemple non supérieure à 50 ou 60°C. Cette température ne permet pas l'utilisation directe simple de l'énergie thermique recueillie.

Ainsi, selon la présente invention, il est prévu de disposer un ensemble auxiliaire 5 constitué de deux fenêtres transparentes entre lesquelles circule le fluide 4 sortant du radiateur 3. Le matériau constitutif des fenêtres de la cellule 5 ainsi que le fluide 4 sont choisis pour présenter des qualités d'absorption optique particulières à savoir qu'ils absorbent la plus grande partie du spectre incident se trouvant à l'extérieur du spectre de réponse de la cellule photovoltaïque 1.

On obtient ainsi le double avantage d'une part de limiter l'échauffement de la cellule 1 en évitant de l'irradier par des rayonnements de longueurs d'ondes ne produisant pas d'effet photovoltaïque, d'autre part d'augmenter la température du fluide à la sortie du dispositif. Ainsi, si le fluide sort du radiateur 3 à une température comprise entre 50 et 60°C, il pourra sortir de l'ensemble 5 à une température de l'ordre de 70 à 80°C, ce qui le rend plus directement utilisable pour diverses applications thermiques. Notamment, le fluide pourra être de l'eau éventuellement additionnée d'un agent particulier pour absorber les longueurs d'ondes supérieures à 1,1 micron. Si l'on ne veut pas que l'ensemble 5 absorbe les rayonnements ultraviolets, on pourra choisir pour cet ensemble des fenêtres en quartz.

Comme le montre la figure 2, la cellule solaire 1 sera de préférence liée au radiateur ou barre à eau 3 par l'intermédiaire d'un support thermiquement conducteur 6.

En figure 1, on a représenté la lumière concentrée sur la cellule 1. On pourra préférer concentrer le faisceau lumineux en provenance du réflecteur 2 au niveau de l'ensemble d'absorption des rayonnements parasites 5, la lumière étant défocalisée au niveau de la cellule 1.

Cette cellule 1 peut notamment être du type cellules au silicium à multijonctions verticales, telles que décrites notamment dans l'article de B.L. Sater et al publié dans l'ouvrage intitulé "Solar Cells" édité par C.E. Backus aux I.E.E.E. Press en 1976, pages 311 à 316.

La présente invention n'est pas limitée aux modes de réalisation qui ont été explicitement décrits ci-dessus; elle en

4

inclut les diverses variantes et généralisations comprises dans le domaine des revendications ci-après.

5

## REVENDICATIONS

1. Procédé de refroidissement d'une cellule photovoltaïque solidaire d'un radiateur à circulation de fluide, caractérisé en ce qu'il consiste à disposer, devant la cellule et dans le trajet du rayonnement incident, un ensemble traversé par le fluide de refroidissement absorbant au moins une partie du rayonnement incident dont le spectre se trouve en dehors de la zone de sensibilité de la cellule.

2. Procédé selon la revendication 1, caractérisé en ce que ledit ensemble comprend des fenêtres transparentes entre lesquelles circule le fluide et en ce que les matériaux constitutifs des fenêtres et du fluide sont choisis pour qu'au moins une partie du rayonnement absorbé le soit directement par le fluide.

3. Dispositif solaire mixte photovoltaïque et photothermique à lumière concentrée comprenant une cellule photovoltaïque solidaire d'un radiateur dans lequel circule un fluide de refroidissement, caractérisé en ce qu'il comprend en outre :

- un ensemble disposé dans le trajet du faisceau incident,

- des moyens pour faire circuler le fluide sortant du radiateur dans ledit ensemble,

ledit ensemble absorbant, en coopération avec le fluide, une partie au moins du rayonnement incident située hors de la bande spectrale de réponse de la cellule photovoltaïque et transmettant les calories recueillies au fluide de refroidissement.

4. Dispositif selon la revendication 3, caractérisé en ce que ledit ensemble comprend des fenêtres transparentes entre lesquelles circule le fluide de refroidissement.

5. Dispositif selon la revendication 4, caractérisé en ce que le fluide de refroidissement est de l'eau.

6. Dispositif selon la revendication 4, caractérisé en ce que les fenêtres sont en quartz.

7. Dispositif selon la revendication 4, caractérisé en ce que la lumière incidente est focalisée sur ledit ensemble et est légèrement défocalisée au niveau de la cellule photovoltaïque.

8. Dispositif selon l'une quelconque des revendications 3 à 7, caractérisé en ce que la cellule photovoltaïque est du type cellule au silicium à multijonctions verticales.

9. Dispositif selon la revendication 8, caractérisé en ce que ledit ensemble absorbe essentiellement la partie du rayonnement incident de longueurs d'ondes supérieures à 1,1 micron.

Fig.1

Fig.2